# EUROPEAN PATENT APPLICATION

(11) **EP 2 003 942 A2**
(43) Date of publication of application: **17.12.2008**
(21) Application number: 08156905.5
(22) Date of filing: 26.05.2008
(51) Int. Cl.: H05K 3/30, H05K 7/20

(54) **Method of assembly to achieve thermal bondline with minimal lead bending**

(30) Priority: 15.06.2007 US 818840
(71) Applicant: Delphi Technologies, Inc., Troy, Michigan 48007 (US)
(72) Inventor: Sozansky, Wayne A., Greentown, IN 46936 (US)
(74) Representative: Denton, Michael John

(57) **Abstract**

An improved process for assembling a plurality of power packages and a thermal heat sink to a printed circuit board involves securing the power packages to the heat sink before soldering the electrical leads of the power packages to the printed circuit board. The improved process allows the electrical leads of the power packages to move freely in lead holes in the printed circuit board as intimate planar surface to planar surface contact between the heat sink and the power packages is achieved, thereby eliminating or at least substantially reducing lead bending that occurs in conventional processes wherein attachment of the heat sink to the power packages occurs after the leads of the power packages have been soldered to the printed circuit board.

## Description

### Technical Field

This invention relates to methods of assembling discrete power packages and a heat sink on a printed circuit board.

### Background of the Invention

Conventional processes for physically and electrically connecting a plurality of leaded power packages to a printed circuit board have involved applying plastic standoff spacers to the printed circuit board, inserting the power packages onto the printed circuit board with the leads extending through lead holes provided in the printed circuit board, holding the properly positioned package in place on the printed circuit board with a suitable clamping fixture, and wave soldering the leads to the underside of the printed circuit board. Thereafter, the assembly comprising the power packages wave soldered to the printed circuit board is detached from the clamping fixture and attached to a heat sink or rail. Intimate contact or minimal space between the power package surface and the heat rail is desired. However, the typical assembly process creates differences in height among the power packages on the printed circuit board. The typical assembly process also causes individual power packages to be tilted with respect to each other at different angles.

To achieve intimate contact across the entire package area using known techniques, the package leads must be bent so that the outer surfaces of the discrete power packages are all at the same height and located in substantially the same plane. Typically, a clamping mechanism is also needed to hold the power device in contact with the heat rail due to the resilient memory (i.e., the tendency for a metal to return or spring back toward its original shape after deformation) of the bent leads. Using the circuit board as the reference plane for positioning of the power devices in accordance with conventional processes causes the amount of lead bending to be equal to the sum of tolerances (i.e., dimensional variations) for circuit board warpage, lead forming, power device thickness and heat sink flatness. This bending, which is typically greater than 0.01 inches in magnitude, can cause physical damage to the power package resulting in reduced quality and reduced reliability of the assembly.

### Summary of the Invention

The process of the invention eliminates, or at least substantially reduces, bending of leads during assembly of power packages and a thermal heat sink or rail on a printed circuit board. Bending is eliminated or at least substantially reduced by attaching the power packages to the heat rail prior to attaching the leads to the printed circuit board. After the power packages are attached to the thermal heat sink or rail, the leads are inserted through the appropriate lead holes in the circuit board and are allowed to move freely without bending during a subsequent soldering step. Because intimate contact between the upper or outer exposed surfaces of the power packages and the thermal heat sink or rail is achieved or perfected prior to soldering of the leads of the power packages to the printed circuit board, and because the leads move freely through the appropriate lead holes in the printed circuit board during the soldering process, final assembly can be achieved without significant bending of the leads.

Using the heat sink as a reference plane for positioning of the power devices in accordance with this invention eliminates lead bending contributions attributable to tolerances (i.e., dimensional variations) for board warpage, lead forming, power device thickness and heat sink flatness. The processes of this invention allow the solder joint to compensate for these variations.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a schematic flow diagram of a conventional process for assembling power packages and a heat sink on a printed circuit board.
FIG. 2 is a schematic flow diagram of a process in accordance with the invention for assembling power packages and a heat sink on a printed circuit board.
FIG. 3 is a cross-sectional elevational view of a subassembly being prepared using a subassembly fixture in accordance with the invention.
FIG. 4 is a cross-sectional elevational view of a wave soldering step that may be used in accordance with the invention to complete the assembly.
FIG. 4A is cross-sectional elevational view of an alternative embodiment in which the heat sink includes standoffs and fasteners to attach the heat sink directly to a printed circuit board.
FIG. 5 is a histogram that is normalized to show the variation of thermal bondline thickness using a process of this invention, and using a conventional process.

### Description of the Prior Art

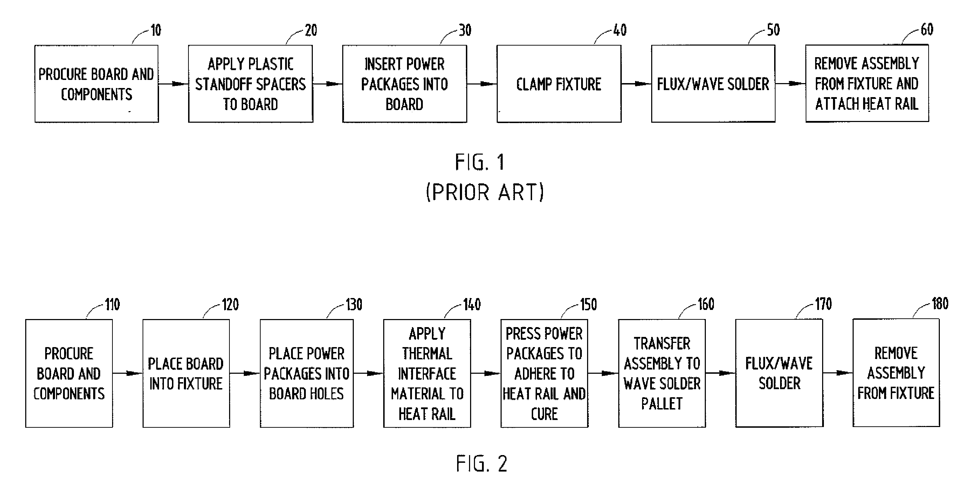

The steps in a conventional process for assembling power packages and a thermal heat rail on a printed circuit board is illustrated schematically in FIG. 1. The first step 10 involves procurement of a printed circuit board having appropriate printed circuitry for the power packages and appropriately located lead holes for the leads of the power packages, and procurement of the power packages and heat sink. Thereafter, a step 20 of applying plastic standoff spacers to the printed circuit board is performed. The plastic standoff spacers are intended to provide the correct spacing between the power packages and the circuit board. Next, the leads on the power packages are inserted into the corresponding lead holes in the printed circuit board in step 30. A clamp fixture in step 40 is used for holding the power packages against the plastic standoffs so that the power packages are held in place during a soldering operation 50. Thereafter, the subassemblies comprising the power packages soldered to the printed circuit board are removed from the fixture and a heat rail is affixed to the outer exposed surfaces of the power packages in step 60.

Unfortunately, the process described above and shown in FIG. 1 results in differences among the height of the plurality of power packages mounted on the printed circuit board, and also results in individual power packages being tilted at an angle with respect to each other and with respect to the printed circuit board. As a result, in order to achieve excellent planar contact between the outer exposed surfaces of the power packages and a surface of the planar heat sink or heat rail, the leads on the power packages must be bent slightly. However, excessive bending (e.g., more than about 0.010 inch) can cause physical damage to the power package resulting in reduced quality and reduced reliability.

### Description of the Preferred Embodiments

A process in accordance with the invention is illustrated schematically in FIG. 2. Procurement step 110 is substantially the same as procurement step 10 of FIG. 1. The printed circuit board in accordance with the process of this invention is placed into a fixture during step 120 to immobilize the printed circuit board during subsequent operations. Next, in step 130, the electrical leads of the power packages are inserted into corresponding lead holes provided in the printed circuit board. Thermal interface adhesive material is then applied to the heat rail in step 140. Thereafter, in step 150, the outwardly facing surfaces of the power packages, opposite the surfaces facing toward the printed circuit board, are pressed against the adhesive material applied to the heat rail to secure the power packages to the heat rail.

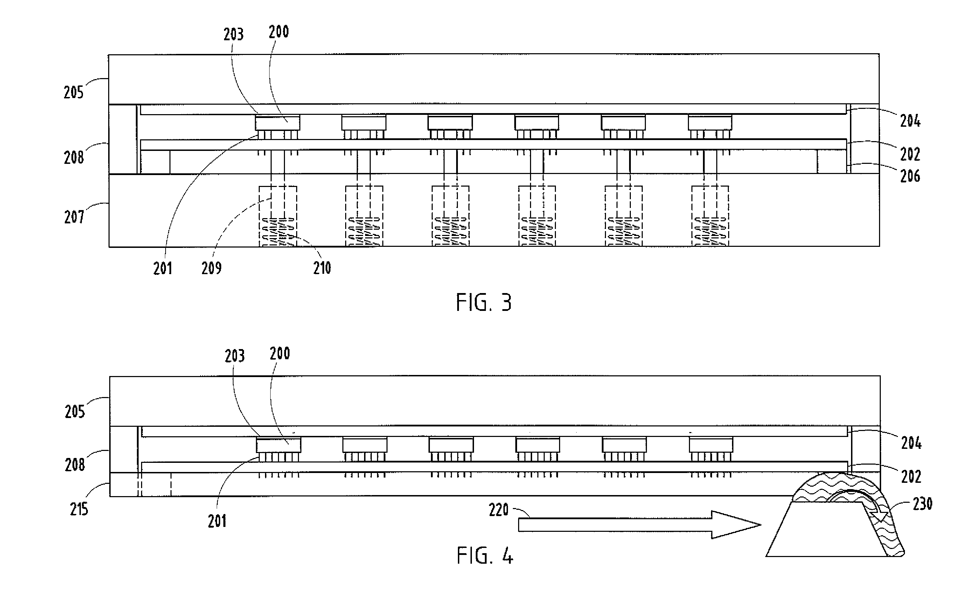

With excellent planar heat rail surface to planar power package surface contact being provided while the leads are still loosely inserted in the printed circuit board, the subassembly is transferred, in step 160, to a wave solder pallet and the leads of the power packages are wave soldered in step 170 to the printed circuit board. Finally, in step 180, the completed assembly is removed from a fixture used during the soldering step.
A suitable fixture for preparing a subassembly in which the power packages 200 are attached to a heat rail 204 is shown in FIG. 3. The expression "power packages" as used herein refers to an electrical or electronic component that generates a substantial amount of heat that must be, or at least is desirably, dissipated by a heat sink attached to the power packages. Examples of power packages include transistors such as a MOSFET (metal oxide semiconductor field effect transistor), IGBT (isolated gate bipolar transistor), diode, thyristor, etc. The fixture includes a base 207, an upper fixture member 205 and standoffs 208. Circuit board 202 is positioned on circuit board supports 206 (located at each of the four corners of the printed circuit board). The electrical leads 201 of the power packages 200 are inserted into the corresponding holes provided in the printed circuit board 202. The power packages 200 may be affixed to the thermal heat sink 204 with a thermal interface adhesive material 203 that may be appropriately patterned onto the underside of a thermal heat sink 204 (e.g., an aluminum plate), the upper surface power devices 200, or both the underside of thermal heat sink 204 and the upper surface of power devices 200.

As an alternative to adhesively affixing an upper surface of the power packages to the printed circuit board, the power packages may be temporarily affixed to the heat sink using a mechanical clamp mechanism. After soldering is complete, the power devices may be held in intimate contact with the heat sink using a spring fixture similar to that described above and illustrated in FIG. 3.

Before and during assembly of the fixture (205, 207 and 208) around the subassembly, power packages 200 are loosely held on printed circuit board 202. A force may be applied to the underside of the power packages using springs 210 that act through plungers or pins 209 which extend upwardly from spring 210 and through a plunger aperture provided through printed circuit board 202. The spring 210 may be an elastomeric member, a metal coil spring, a metal leaf spring or any other suitable means for urging power packages 200 against heat rail or heat sink 204. The fixture is used to achieve intimate planar surface to planar surface contact between the power packages 200 and the heat sink 204.

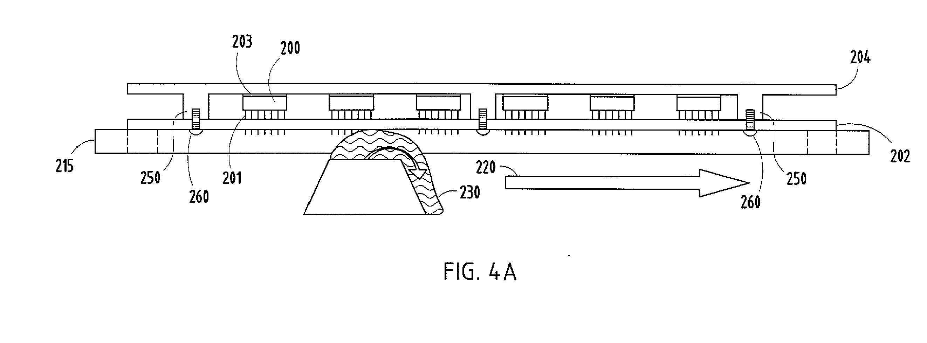

After the power packages have been attached to the heat sink, the same fixture may be used for wave soldering the leads 201 of the power packages 200 as shown in FIG. 4. During wave soldering, the base portion 207 of the fixture is removed and the underside of printed circuit board 202 is moved in the direction shown by arrow 220 to pass the portions of leads 201 extending through circuit board 202 through a schematically illustrated solder wave 230.

As an alternative to using the upper fixture to hold the heat sink and power devices in place during soldering, a rigid heat sink may itself be used as a fixturing device as shown in FIG. 4A. By including standoff features 250 on the heat sink, a fixed height above the circuit board can be established. Screws or other suitable fasteners 260 may be used to attach the heat sink directly to the board. This method limits board movement during the solder process and provides additional structural strength to the final assembly.

Employing a process of this invention using an adhesive to bond the power packages 200 to the thermal heat sink 204, it was found that very uniform bondline thicknesses (the thickness of the adhesive layer between the power packages and the thermal heat sink) could be achieved.

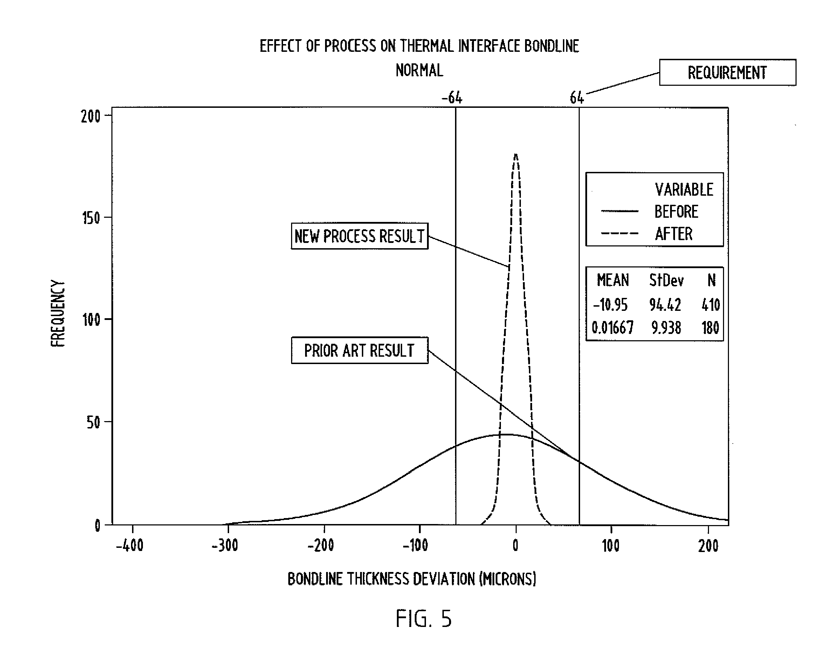

FIG. 5 shows a comparison of the bondline thicknesses achieved using an assembly process of the invention with the bondline thicknesses achieved when a conventional process is used to assemble the same components. The histogram of FIG. 5 shows that all measured bondline thicknesses were well within a targeted or required tolerance (± 64 microns), whereas the conventional process produced a high rate (frequency) of measurements that were well outside of the targeted or required variance.

It will be understood by those who practice the invention and those skilled in the art that various modifications and improvements may be made to the invention without departing from the spirit of the disclosed concept. The scope of protection afforded is to be determined by the claims and by the breadth of interpretation allowed by law.

## Claims

1. A process for assembling a printed circuit board, a plurality of power packages and a thermal heat sink, comprising steps of:
providing a plurality of power packages having electrical leads;
providing a printed circuit board having printed circuitry and lead holes for the power packages;
inserting the electrical leads of the power packages into the lead holes of the printed circuit board;
affixing an upper surface of each of the power packages to a thermal heat sink; and
soldering the electrical leads of the plurality of power packages to the printed circuit board.

2. The process of claim 1, wherein the plurality of power packages are attached to the heat sink and positioned on the printed circuit board by steps of:
placing the printed circuit board into a fixture that holds the printed circuit board in a fixed position and orientation;
positioning the plurality of power packages onto the printed circuit board with the leads of the power packages extending into corresponding lead holes of the printed circuit board;
applying a thermal interface adhesive material to an underside of a heat sink;
holding the underside of the heat sink against outwardly facing surfaces of the power packages; and
exerting a force against the side of each of the power packages opposite the outwardly facing side to urge the outwardly facing surfaces of the power packages against the heat sink.

3. The process of claim 2, wherein the forces applied to the power packages are applied through a plunger projecting through an opening in the printed circuit board.

4. The process of claim 2, wherein the force exerted against the power packages to urge the power packages against the heat sink is provided by springs attached to the fixture.

5. The process of claim 4, wherein the springs are elastomeric members.

6. The process of claim 4, wherein the springs are metal coil springs or leaf springs.

7. The process of claim 1, wherein the thermal heat sink is an aluminum plate.

8. The process of claim 1, wherein the step of soldering comprising moving an underside of the printed circuit board toward a solder wave to pass portions of electrical leads extending from power packages above the printed circuit board and projecting downwardly from the underside of the circuit board through the solder wave.

9. The process of claim 1, wherein the step of affixing an upper surface of each of the power packages to a thermal heat sink includes applying an adhesive to at least one of the upper surfaces of the power packages and the underside of the thermal heat sink, and urging the upper surfaces of the power packages against the underside of the thermal heat sink.

10. The process of claim 1, wherein the step of affixing an upper surface of each of the power packages to a thermal heat sink includes mechanically clamping the power packages on the thermal heat sink.
